# EUROPEAN PATENT APPLICATION

(11) **EP 3 696 846 A1**
(43) Date of publication of application: **19.08.2020**
(21) Application number: 19157009.2
(22) Date of filing: 13.02.2019
(51) Int. Cl.: H01J 37/04, H01J 37/05, H01J 37/26

(54) **APPARATUS FOR AND METHOD OF PRODUCING A MONOCHROMATIC CHARGED PARTICLE BEAM**

(71) Applicant: ASML Netherlands B.V., 5500 AH Veldhoven (NL)
(72) Inventor: HASAN, Shakeeb Bin, 5500 AH Veldhoven (NL); REN, Yan, 5500 AH Veldhoven (NL)
(74) Representative: Peters, John Antoine

(57) **Abstract**

Disclosed among other aspects is a charged particle inspection system including a passive monochromator arranged to modify the energy distribution of electrons in a beam to reduce the energy spread of the electrons, with the passive monochromator including a metamaterial absorber configured as absorbing structures provided on a transparent conductive layer and a method using such a passive monochromator.

## Description

### Technical Field

The embodiments provided herein relate to a charged particle device with one or more charged particle beams, such as an electron microscopy apparatus utilizing one or more electron beams.

### Background

Integrated circuits are made by creating patterns on a wafer, also called a substrate. The wafer is supported on a wafer stage in the equipment for creating the pattern. One part of the process for making the integrated circuits involves looking at or "inspecting" parts of the wafer. This may be done with a scanning electron microscope or SEM.

The use of SEMs in photolithography increasingly require low electron probing energies to minimize radiation damage and to mitigate charging effects. Extremely low landing energies are required for SEM observations to allow the subsurface and nanoscale information of target specimens to be measured with minimized charge-up and minimized beam damage depths caused by reduced interaction volumes. As the probing energy is lowered, however, the deleterious effect of the objective lens chromatic aberration becomes pronounced, thereby limiting the achievable spatial resolution. The energy spread of the beam causes chromatic aberration. This spread can be reduced with a monochromator.

### Summary

The following presents a simplified summary of one or more embodiments in order to provide a basic understanding of the embodiments. This summary is not an extensive overview of all contemplated embodiments, and is not intended to identify key or critical elements of all embodiments nor delineate the scope of any or all embodiments. Its sole purpose is to present some concepts of one or more embodiments in a simplified form as a prelude to the more detailed description that is presented later.

According to an aspect of an embodiment, there is disclosed an apparatus for and method of reducing the energy spread of electrons in an electron beam using a monochromator including metamaterial absorbers.

According to another aspect of an embodiment there is disclosed an apparatus for narrowing an energy spread of an electron beam, the apparatus comprising structure defining a cavity extending along a part of a path of the electron beam, the cavity having an interior surface, and a metamaterial absorber provided on the interior surface. The metamaterial absorber may include a layer of a dielectric material on at least part of the interior surface wherein the layer of a transparent conductive material may be provided with a plurality of absorbing structures. The metamaterial absorber may include a layer of a transparent conductive material on at least part of the interior surface wherein the layer of a transparent conductive material may be provided with a plurality of absorbing structures. The absorbing structures may be metamaterial perfect absorbers. The absorbing structures may be plasmonic structures. The absorbing structures may be configured to resonantly absorb electromagnetic energy. The absorbing structures may be at least partially embedded in the layer of transparent conductive material. The absorbing structures may be fabricated on top of the layer of transparent conductive material. The absorbing structures may be printed on the layer of transparent conductive material. The absorbing structures may comprise a plurality of block-shaped elements comprising a metallic material. The absorbing structures may comprise graphene. The absorbing structures may comprise a plurality of graphene flakes. The absorbing structures may comprise a combination of a plurality of block-shaped metallic elements and a plurality of graphene flakes. The absorbing structures may be arranged in a periodic array. The pitch of the periodic array may be selected to achieve maximum absorption of energy from the electron beam. The transparent conductive material may include indium-tin-oxide. The transparent conductive material may include doped zinc oxide. The transparent conductive material may include carbon nanotubes. The transparent conductive material may comprise an amorphous material. The transparent conductive material may include a doped transparent semiconductor. The transparent conductive material may include a conductive polymer. The transparent conductive material may include a body comprising a transparent material and coating of a conductive material. The coating of a conductive material may include gold. The coating of a conductive material may include aluminum. The coating of a conductive material may include titanium. The coating of a conductive material may include chromium. The structure may include a substantially cylindrical column. A length of the part of the column traversed by the electron beam may be chosen to cause a predetermined amount of deceleration of electrons in the electron beam. The substantially cylindrical column may include an electrically conductive material. The electrically conductive material may include gold. The electrically conductive material may include silver. The electron beam may propagate along a central axis of the column. The radius of the substantially cylindrical column may decrease in a direction the electron beam propagates. The dimensions or pitch of the absorbing structures may vary in a direction in which the electron beam propagates.

According to another aspect of an embodiment there is disclosed an apparatus for generating a substantially monochromatic electron beam, the apparatus comprising a source of an electron beam, a monochromator comprising a metamaterial absorber arranged to interact with the electron beam to produce a substantially monochromatic electron beam, an objective lens arranged to focus the substantially monochromatic electron beam. The monochromator may include a structure defining a cavity having an interior surface and a metamaterial absorber provided on the interior surface. The metamaterial absorber may include a layer of a dielectric material on at least part of the interior surface wherein the layer of a transparent conductive material may be provided with a plurality of absorbing structures. The metamaterial absorber may include a layer of a transparent conductive material on at least part of the interior surface wherein the layer of a transparent conductive material may be provided with a plurality of absorbing structures. The absorbing structures may be metamaterial perfect absorbers. The absorbing structures may be plasmonic structures. The absorbing structures may be configured to resonantly absorb electromagnetic energy. The absorbing structures may be at least partially embedded in the layer of transparent conductive material. The absorbing structures may be fabricated on top of the layer of transparent conductive material. The absorbing structures may be printed on the layer of transparent conductive material. The absorbing structures may comprise a plurality of block-shaped elements comprising a metallic material. The absorbing structures may comprise graphene. The absorbing structures may comprise a plurality of graphene flakes. The absorbing structures may comprise a combination of a plurality of block-shaped metallic elements and a plurality of graphene flakes. The absorbing structures may be arranged in a periodic array. The pitch of the periodic array may be selected to achieve maximum absorption of energy from the electron beam. The transparent conductive material may include indium-tin-oxide. The transparent conductive material may include doped zinc oxide. The transparent conductive material may include carbon nanotubes. The transparent conductive material may comprise an amorphous material. The transparent conductive material may include a doped transparent semiconductor. The transparent conductive material may include a conductive polymer. The transparent conductive material may include a body comprising a transparent material and coating of a conductive material. The coating of a conductive material may include gold. The coating of a conductive material may include aluminum. The coating of a conductive material may include titanium. The coating of a conductive material may include chromium. The structure may include a substantially cylindrical column. A length of the part of the column traversed by the electron beam may be chosen to cause a predetermined amount of deceleration of electrons in the electron beam. The substantially cylindrical column may include an electrically conductive material. The electrically conductive material may include gold. The electrically conductive material may include silver. The electron beam may propagate along a central axis of the column. The radius of the substantially cylindrical column may decrease in a direction the electron beam propagates. The dimensions or pitch of the absorbing structures may vary in a direction in which the electron beam propagates.

According to another aspect of an embodiment there is disclosed an apparatus for generating a substantially monochromatic electron beam, the apparatus comprising a first aperture arranged to obstruct part of the electron beam to produce a modified electron beam, at least one electromagnetic condenser lens arranged to collimate the modified electron beam to produce a collimated electron beam, a second aperture arranged to obstruct part of the collimated electron beam to produce a modified collimated electron beam, a passive monochromator comprising a metamaterial absorber arranged to interact with the modified collimated electron beam to arrow an energy spread of the electron beam, and an objective lens arranged to focus the electron beam from the passive monochromator. The passive monochromator may include a structure defining a cavity having an interior surface and a metamaterial absorber provided on the interior surface. The metamaterial absorber may include a layer of a dielectric material on at least part of the interior surface wherein the layer of a transparent conductive material may be provided with a plurality of absorbing structures. The metamaterial absorber may include a layer of a transparent conductive material on at least part of the interior surface wherein the layer of a transparent conductive material may be provided with a plurality of absorbing structures. The absorbing structures may be metamaterial perfect absorbers. The absorbing structures may be plasmonic structures. The absorbing structures may be configured to resonantly absorb electromagnetic energy. The absorbing structures may be at least partially embedded in the layer of transparent conductive material. The absorbing structures may be fabricated on top of the layer of transparent conductive material. The absorbing structures may be printed on the layer of transparent conductive material. The absorbing structures may comprise a plurality of block-shaped elements comprising a metallic material. The absorbing structures may comprise graphene. The absorbing structures may comprise a plurality of graphene flakes. The absorbing structures may comprise a combination of a plurality of block-shaped metallic elements and a plurality of graphene flakes. The absorbing structures may be arranged in a periodic array. The pitch of the periodic array may be selected to achieve maximum absorption of energy from the electron beam. The transparent conductive material may include indium-tin-oxide. The transparent conductive material may include doped zinc oxide. The transparent conductive material may include carbon nanotubes. The transparent conductive material may comprise an amorphous material. The transparent conductive material may include a doped transparent semiconductor. The transparent conductive material may include a conductive polymer. The transparent conductive material may include a body comprising a transparent material and coating of a conductive material. The coating of a conductive material may include gold. The coating of a conductive material may include aluminum. The coating of a conductive material may include titanium. The coating of a conductive material may include chromium. The structure may include a substantially cylindrical column. A length of the part of the column traversed by the electron beam may be chosen to cause a predetermined amount of deceleration of electrons in the electron beam. The substantially cylindrical column may include an electrically conductive material. The electrically conductive material may include gold. The electrically conductive material may include silver. The electron beam may propagate along a central axis of the column. The radius of the substantially cylindrical column may decrease in a direction the electron beam propagates. The dimensions or pitch of the absorbing structures may vary in a direction in which the electron beam propagates.

According to another aspect of an embodiment, there is disclosed an apparatus for narrowing an energy spread of an electron beam, the apparatus comprising structure defining a cavity extending along a part of a path of the electron beam, the cavity having an interior surface, the interior surface being adapted to absorb energy from electrons in the electron beam to narrow an energy spread of the electron beam. The interior surface may include a metamaterial absorber. The metamaterial absorber may include a layer of a dielectric material on at least part of the interior surface wherein the layer of a transparent conductive material may be provided with a plurality of absorbing structures. The metamaterial absorber may include a layer of a transparent conductive material on at least part of the interior surface wherein the layer of a transparent conductive material may be provided with a plurality of absorbing structures. The absorbing structures may be metamaterial perfect absorbers. The absorbing structures may be plasmonic structures. The absorbing structures may be configured to resonantly absorb electromagnetic energy. The absorbing structures may be at least partially embedded in the layer of transparent conductive material. The absorbing structures may be fabricated on top of the layer of transparent conductive material. The absorbing structures may be printed on the layer of transparent conductive material. The absorbing structures may comprise a plurality of block-shaped elements comprising a metallic material. The absorbing structures may comprise graphene. The absorbing structures may comprise a plurality of graphene flakes. The absorbing structures may comprise a combination of a plurality of block-shaped metallic elements and a plurality of graphene flakes. The absorbing structures may be arranged in a periodic array. The pitch of the periodic array may be selected to achieve maximum absorption of energy from the electron beam. The transparent conductive material may include indium-tin-oxide. The transparent conductive material may include doped zinc oxide. The transparent conductive material may include carbon nanotubes. The transparent conductive material may comprise an amorphous material. The transparent conductive material may include a doped transparent semiconductor. The transparent conductive material may include a conductive polymer. The transparent conductive material may include a body comprising a transparent material and coating of a conductive material. The coating of a conductive material may include gold. The coating of a conductive material may include aluminum. The coating of a conductive material may include titanium. The coating of a conductive material may include chromium. The structure may include a substantially cylindrical column. A length of the part of the column traversed by the electron beam may be chosen to cause a predetermined amount of deceleration of electrons in the electron beam. The substantially cylindrical column may include an electrically conductive material. The electrically conductive material may include gold. The electrically conductive material may include silver. The electron beam may propagate along a central axis of the column. The radius of the substantially cylindrical column may decrease in a direction the electron beam propagates. The dimensions or pitch of the absorbing structures may vary in a direction in which the electron beam propagates.

According to another aspect of an embodiment there is disclosed a method of reducing a width of an energy distribution in a beam of electrons, the method comprising the step of passing the beam through a volume of space defined by a structure extending along a path of the beam, the surface being provided with a metamaterial absorber arranged to absorb energy from the electrons. The metamaterial absorber may include a layer of a transparent conductive material on at least part of the interior surface wherein the layer of a transparent conductive material may be provided with a plurality of absorbing structures. The metamaterial absorber may include a layer of a dielectric material on at least part of the interior surface wherein the layer of a transparent conductive material may be provided with a plurality of absorbing structures. The metamaterial absorber may include a layer of a transparent conductive material on at least part of the interior surface wherein the layer of a transparent conductive material may be provided with a plurality of absorbing structures. The absorbing structures may be metamaterial perfect absorbers. The absorbing structures may be plasmonic structures. The absorbing structures may be configured to resonantly absorb electromagnetic energy. The absorbing structures may be at least partially embedded in the layer of transparent conductive material. The absorbing structures may be fabricated on top of the layer of transparent conductive material. The absorbing structures may be printed on the layer of transparent conductive material. The absorbing structures may comprise a plurality of block-shaped elements comprising a metallic material. The absorbing structures may comprise graphene. The absorbing structures may comprise a plurality of graphene flakes. The absorbing structures may comprise a combination of a plurality of block-shaped metallic elements and a plurality of graphene flakes. The absorbing structures may be arranged in a periodic array. The pitch of the periodic array may be selected to achieve maximum absorption of energy from the electron beam. The transparent conductive material may include indium-tin-oxide. The transparent conductive material may include doped zinc oxide. The transparent conductive material may include carbon nanotubes. The transparent conductive material may comprise an amorphous material. The transparent conductive material may include a doped transparent semiconductor. The transparent conductive material may include a conductive polymer. The transparent conductive material may include a body comprising a transparent material and coating of a conductive material. The coating of a conductive material may include gold. The coating of a conductive material may include aluminum. The coating of a conductive material may include titanium. The coating of a conductive material may include chromium. The structure may include a substantially cylindrical column. A length of the part of the column traversed by the electron beam may be chosen to cause a predetermined amount of deceleration of electrons in the electron beam. The substantially cylindrical column may include an electrically conductive material. The electrically conductive material may include gold. The electrically conductive material may include silver. The electron beam may propagate along a central axis of the column. The radius of the substantially cylindrical column may decrease in a direction the electron beam propagates. The dimensions or pitch of the absorbing structures may vary in a direction in which the electron beam propagates.

Further features and advantages of the present invention, as well as the structure and operation of various embodiments of the present invention, are described in detail below with reference to the accompanying drawings. It is noted that the present invention is not limited to the specific embodiments described herein. Such embodiments are presented herein for illustrative purposes only. Additional embodiments will be apparent to persons skilled in the relevant art(s) based on the teachings contained herein.

### Brief Description of Figures

The accompanying drawings, which are incorporated herein and form part of the specification, illustrate the present invention and, together with the description, further serve to explain the principles of the present invention and to enable a person skilled in the relevant art(s) to make and use the present invention.
FIG. 1 is a schematic diagram illustrating an exemplary electron beam inspection system, consistent with embodiments of the present disclosure.
FIG. 2 is a schematic diagram illustrating additional aspects of an exemplary electron beam inspection system, consistent with embodiments of the present disclosure.
FIG. 3 is a side view diagram illustrating additional aspects of an exemplary electron beam inspection system, consistent with embodiments of the present disclosure.
FIG. 4A is a partially perspective view of a monochromator such as one could be used in the system of FIG. 3; FIG. 4B is a cross section of FIG. 4A taken along line B-B.
FIG. 5 is a partially perspective view of a monochromator such as one could be used in the system of FIG. 3.
FIG. 6 is a cross sectional view of the monochromator of FIG. 4A.
FIG. 7 is a plan view of a metamaterial absorber according to an aspect of an embodiment
FIG. 8 is a plan view of a metamaterial absorber according to an aspect of an embodiment.
FIG. 9 is a flowchart showing exemplary steps in a method according to an aspect of an embodiment.

### Detailed Description

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of systems, apparatus, and methods consistent with aspects related to the invention as recited in the appended claims. Relative dimensions of components in drawings may be exaggerated for clarity.

Electronic devices are constructed of circuits formed on a piece of silicon called a substrate. Many circuits may be formed together on the same piece of silicon and are called integrated circuits or ICs. The size of these circuits has decreased dramatically so that many more of them can fit on the substrate. For example, an IC chip in a smart phone can be as small as a thumbnail and yet may include over 2 billion transistors, the size of each transistor being less than 1/1000th the size of a human hair.

Making these extremely small ICs is a complex, time-consuming, and expensive process, often involving hundreds of individual steps. Errors in even one step have the potential to result in defects in the finished IC rendering it useless. Thus one goal of the manufacturing process is to avoid such defects to maximize the number of functional ICs made in the process, that is, to improve the overall yield of the process.

One component of improving yield is monitoring the chip making process to ensure that it is producing a sufficient number of functional integrated circuits. One way to monitor the process is to inspect the chip circuit structures at various stages of their formation. Inspection can be carried out using a scanning electron microscope (SEM). An SEM can be used to image these extremely small structures, in effect, taking a "picture" of the structures. The image can be used to determine if the structure was formed properly and also if it was formed in the proper location. If the structure is defective then the process can be adjusted so the defect is less likely to recur.

As the name implies, SEMs use beams of electrons because such beams can be used to see structures that are too small to be seen by optical microscopes, that is, microscopes using light. The electrons in the electron beam(s) will not all have exactly the same energy. Instead, there will be a spread in the energy which is sometimes referred to as ΔE. It is desirable when obtaining an SEM image, however, to use electrons having energies as close together as possible. In other words it is desirable to make ΔE as small as possible. A beam in which all of the electrons have nearly the same energy is referred to as monochromatic. Similarly, a device that makes the energy spread of the beam smaller is referred to as a monochromator.

A monochromator typically separates electrons with different energies, and uses a slit to select electrons with the right energy and block the others, that is, electrons not having the right energy. In such a monochromator, electrons with different energies are separated and only a small portion of electrons with desired energy are selected. The cost of improving imaging resolution using such a monochromator is thus to lose most of electrons in an electron beam, making throughput of a SEM low. One way around this problem is to keep all of the electrons but to slow some of them down so that they all have about the same energy. Usually this requires passing the electrons through an electric field, which adds complications. It would be better to be able to decelerate the faster electrons so that the electrons' speeds match using a device that reduces the electron energy passively, that is, without having to impose an external electric field. One of several disclosures in this application is such a system, in which an absorber effectively siphons off the electron energy in such a way that the electrons all end up with about the same energy. Of course, this is an approximate description, and the actual details are set forth more completely and precisely below.

Without limiting the scope of the present disclosure, descriptions and drawings of embodiments may be exemplarily referred to as using an electron beam. However, the embodiments are not used to limit the present invention to specific charged particles. For example, systems and methods for beam forming may be applied to photons, x-rays, and ions, etc. Furthermore, the term "beam" may refer to primary electron beams, primary electron beamlets, secondary electron beams, or secondary electron beamlets, among others.

As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

In the description and in the claims the terms "up," "down," "top," "bottom," "vertical," "horizontal," and like terms may be employed. These terms are intended to show relative orientation only and not any absolute orientation such as orientation with respect to gravity unless otherwise intended as indicated. Similarly, terms such as left, right, front, back, etc., are intended to give only relative orientation.

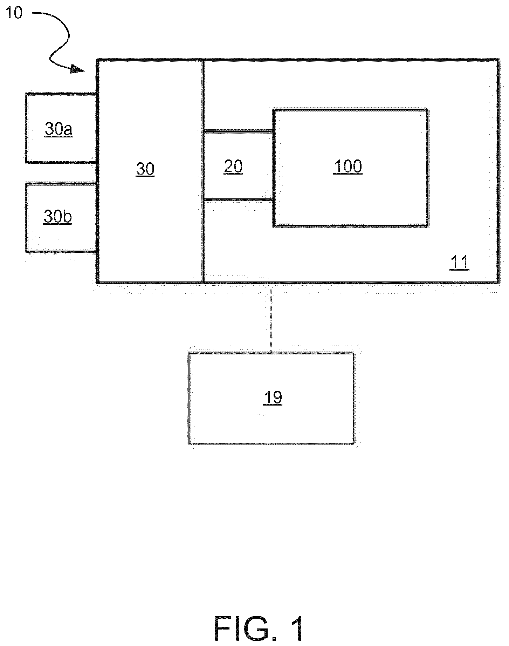

Reference is now made to FIG. 1, which illustrates an exemplary electron beam inspection (EBI) system 10, consistent with embodiments of the present disclosure. As shown in FIG. 1, EBI system 10 includes a main chamber 11, a load/lock chamber 20, an electron beam tool 100, and an equipment front end module (EFEM) 30. Electron beam tool 100 is located within main chamber 11.

EFEM 30 includes a first loading port 30a and a second loading port 30b. EFEM 30 may include additional loading port(s). First loading port 30a and second loading port 30b may, for example, receive wafer front opening unified pods (FOUPs) that contain wafers (e.g., semiconductor wafers or wafers made of other material(s)) or samples to be inspected (wafers and samples may be collectively referred to as "wafers" hereafter). One or more robotic arms (not shown) in EFEM 30 may transport the wafers to load/lock chamber 20.

Load/lock chamber 20 is connected to a load/lock vacuum pump system (not shown) that removes gas molecules in load/lock chamber 20 to reach a first pressure below the atmospheric pressure. After reaching the first pressure, one or more robotic arms (not shown) may transport the wafer from load/lock chamber 20 to main chamber 11. Main chamber 11 is connected to a main chamber vacuum pump system (not shown), which removes gas molecules in main chamber 11 to reach a second pressure below the first pressure. After reaching the second pressure, the wafer is subject to inspection by electron beam tool 100. Electron beam tool 100 may be a single-beam system or a multi-beam system. A controller 19 is electronically connected to electron beam tool 100. While controller 19 is shown in FIG. 1 as being outside of the structure that includes main chamber 11, load/lock chamber 20, and EFEM 30, it is appreciated that controller 19 may be part of the structure.

While the present disclosure provides examples of main chamber 11 housing an electron beam inspection system, it should be noted that aspects of the disclosure in their broadest sense, are not limited to a chamber housing an electron beam inspection system. Rather, it is appreciated that the principles discussed herein may also be applied to other tools that operate under the second pressure.

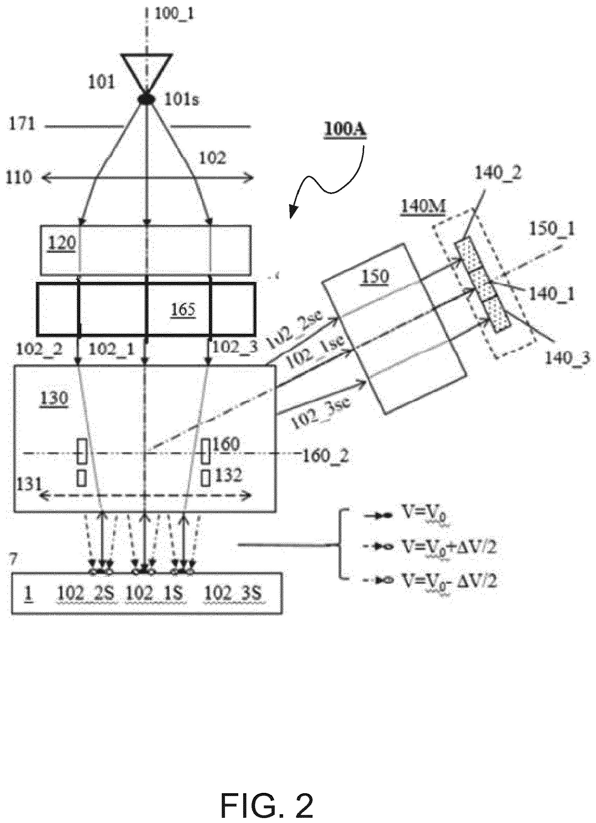

FIG. 2 illustrates an exemplary electron beam tool 100A that may be part of the EBI system of FIG. 1. An electron beam tool 100A (also referred to herein as "apparatus 100A") comprises an electron source 101, a gun aperture plate 171, a condenser lens 110, a source conversion unit 120, a primary projection optical system 130, a secondary imaging system 150, and an electron detection device 140M. Primary projection optical system 130 may comprise an objective lens 131. A sample 1 with sample surface 7 may be provided on a movable stage (not shown). Electron detection device 140M may comprise a plurality of detection elements 140_1, 140_2, and 140_3. A beam separator 160 and a deflection scanning unit 132 may be placed inside primary projection optical system 130.

Electron source 101, gun aperture plate 171, condenser lens 110, source conversion unit 120, beam separator 160, deflection scanning unit 132, and primary projection optical system 130 may be aligned with a primary optical axis 100_1 of apparatus 100A. Secondary imaging system 150 and electron detection device 140M may be aligned with a secondary optical axis 150_1 of apparatus 100A.

Electron source 101 may comprise a cathode (not shown) and an extractor or anode (not shown), in which, during operation, electron source 101 is configured to emit primary electrons from the cathode and the primary electrons are extracted or accelerated by the extractor or the anode to form a primary electron beam 102 that forms a primary beam crossover (virtual or real) 101s. Primary electron beam 102 may be visualized as being emitted from primary beam crossover 101s.

Source conversion unit 120 may comprise an image-forming element array (not shown in FIG. 2) and a beam-limit aperture array (not shown in FIG. 2). The image-forming element array may comprise a plurality of micro-deflectors or micro-lenses that may influence a plurality of primary beamlets 102_1, 102_2, 102_3 of primary electron beam 102 and form a plurality of parallel images (virtual or real) of primary beam crossover 101s, one for each of the primary beamlets 102_1, 201_2, 102_3. The beam-limit aperture array may be configured to limit diameters of individual primary beamlets 102_1, 102_2, and 102_3. FIG. 2 shows three primary beamlets 102_1, 102_2, and 102_3 as an example, and it is appreciated that source conversion unit 120 may be configured to form any number of primary beamlets. For example, source conversion unit 120 may be configured to form a 3×3 array of primary beamlets. Source conversion unit 120 may further comprise an aberration compensator array configured to compensate aberrations of probe spots, 102_1S, 102_2S, and 102_3S. In some embodiments, the aberration compensator array may include a field curvature compensator array with micro-lenses that are configured to compensate field curvature aberrations of probe spots, 102_1S, 102_2S, and 102_3S, respectively. In some embodiments, the aberration compensator array may include an astigmatism compensator array with micro-stigmators that are configured to compensate astigmatism aberrations of probe spots, 102_1S, 102_2S, and 102_3S, respectively. In some embodiments, the image-forming element array, the field curvature compensator array, and the astigmatism compensator array may comprise multiple layers of micro-deflectors, micro-lenses, and micro-stigmators, respectively.

Condenser lens 110 is configured to focus primary electron beam 102. Condenser lens 110 may further be configured to adjust electric currents of primary beamlets 102_1, 102_2, and 102_3 downstream of source conversion unit 120 by varying the focusing power of condenser lens 110. Beamlets 102_1, 102_2, and 102_3 may thereby have a focusing status that may be changed by condenser lens 110. Alternatively, the electric currents may be changed by altering the radial sizes of beam-limit apertures within the beam-limit aperture array corresponding to the individual primary beamlets. Thus, current of a beamlet may be different at different locations along the beamlet's trajectory. Beamlet current may be adjusted so that current of the beamlet on the sample surface (e.g., probe spot current) is set to a desired amount.

Condenser lens 110 may be a movable condenser lens that may be configured so that the position of its first principle plane is movable. The movable condenser lens may be configured to be magnetic, or electrostatic, or electromagnetic (e.g., compound). A movable condenser lens is further described in U.S. Patent No. 9,922,799 and U.S. Patent Application Pub. No. 2017/0025243, both of which are incorporated herein in their entirety. In some embodiments, the condenser lens may be an anti-rotation lens, which may keep rotation angles of off-axis beamlets unchanged while varying the electric currents of the beamlets. In some embodiments, condenser lens 110 may be a movable anti-rotation condenser lens, which involves an anti-rotation lens with a movable first principal plane. An anti-rotation or movable anti-rotation condenser lens is further described in International Application No. PCT/EP2017/084429, which is incorporated by reference in its entirety.

Objective lens 131 may be configured to focus beamlets 102_1, 102_2, and 102_3 onto sample 1 for inspection and may form, in the current embodiment, three probe spots 102_1S, 102_2S, and 102_3S on surface 7. Gun aperture plate 171, in operation, is configured to block off peripheral electrons of primary electron beam 102 to reduce Coulomb effect. The Coulomb effect may enlarge the size of each of probe spots 102_1S, 102_2S, and 102_3S of primary beamlets 102_1, 102_2, 102_3, and therefore deteriorate inspection resolution. Also shown is a beam monochromator 165, as will be described in more detail below.

Deflection scanning unit 132, in operation, is configured to deflect primary beamlets 102_1, 102_2, and 102_3 to scan probe spots 102_1S, 102_2S, and 102_3S across individual scanning areas in a section of surface 7. In response to illumination of sample 1 by primary beamlets 102_1, 102_2, and 102_3 at probe spots 102_1S, 102_2S, and 102_3S, secondary electrons emerge from sample 1 and form three secondary electron beams 102_1se, 102_2se, and 102_3se, which, in operation, are emitted from sample 1. Each of secondary electron beams 102_1se, 102_2se, and 102_3se typically comprise electrons having different energies including secondary electrons (having electron energy ≤ 50eV) and backscattered electrons (having electron energy between 50eV and the landing energy of primary beamlets 102_1, 102_2, and 102_3). Secondary imaging system 150 subsequently focuses secondary electron beams 102_1se, 102_2se, and 102_3se onto detection elements 140_1, 140_2, and 140_3 of electron detection device 140M. Detection elements 140_1, 140_2, and 140_3 are arranged to detect corresponding secondary electron beams 102_1se, 102_2se, and 102_3se and generate corresponding signals that may be sent to signal processing units (not shown) to, for example, construct images of the corresponding scanned areas of sample 1.

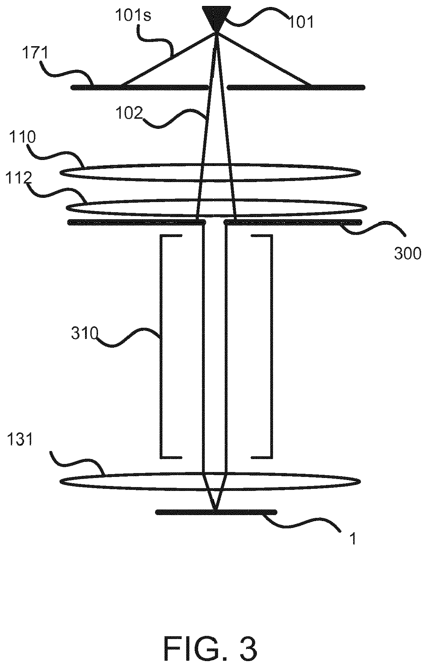

FIG. 3 illustrates an arrangement according to one aspect of an embodiment. In such a system, an electron source 101 is used to generate a large amount of electrons 101s. Aperture 171 is used to remove unnecessary electrons so that Coulomb interactions will be well mitigated. This results in beam 102. Condenser lenses 110 and 112 collimate the electron beam 102. Together with aperture 300, condenser lenses 110 and 112 can be used to change the beam current. A passive monochromator 310 (to be used, for example, as the monochromator 165 in FIG. 2) is provided below, i.e., downbeam from the aperture 300. The function of the passive monochromator 310 is to reduce the energy spread of the electron beam 102. Then an objective lens 131 is used to focus this electron beam 102 on a sample 1.

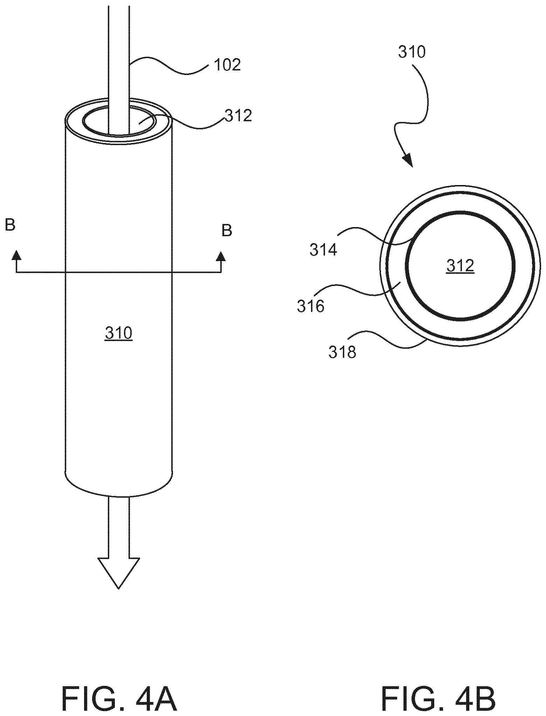

FIG. 4A is a partially perspective view of the passive monochromator 310 shown in FIG. 3. As can be seen, the passive monochromator 310 includes a structure defining a cavity 312 (FIG. 4B) through which the electron beam 102 passes. The cavity 312 may be hollow or it may enclose a material transparent to light or to the electron beam. As shown, the structure may be substantially cylindrical and have a central axis which coincides with the path of the electron beam 102. As shown in FIG. 4B, which is a cross section of the arrangement of FIG. 4A taken along line B-B, surrounding the cavity 312 is a layer of absorbing structures 314 as will be described in more detail below. This layer of absorbing structures 314 is provided on a layer 316 comprising, for example, a dielectric material or a transparent conductive material. A transparent conductive material would conduct stray electrons impinging on the layer 316 away from the device and avoid charging of the walls. In circumstances in which the flux of stray electrons is not expected to be significant, for example, if the beam is sufficiently collimated, then a dielectric material may be used. Numeral 318 denotes the outer wall of the structure which is made of an electrically conductive material. The electrically conductive material may comprise, for example, gold or silver.

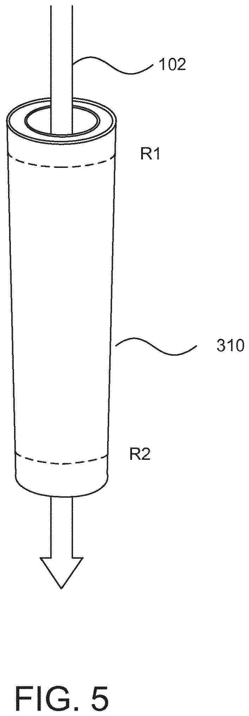

In the arrangement of Fig. 4A, the outer configuration of the passive monochromator 310 is substantially cylindrical. For some applications, however, it may be beneficial to alter the radius of the passive monochromator 310 as a function of position on the beam axis such that the passive monochromator 310 has a first radius where the beam 102 enters the passive monochromator 310 and a second radius where the beam 102 exits the passive monochromator 310. In the example shown in FIG. 5, the circumference R1 is greater than the circumference R2 so that the overall configuration of the passive monochromator 310 is frustoconical. This configuration may make the passive monochromator 310 more efficient at absorbing energy from the electrons in the electron beam 102.

As mentioned above, the passive monochromator 310 may be realized by embedding absorbing structures which resonantly absorb electromagnetic energy at wavelengths determined by the material of which they are composed and to their geometrical features. Due to absorption efficiency reaching almost 100%, these structures are known as plasmonic/metamaterial perfect absorbers. Note that these structures are referred to as "perfect" absorbers in the literature and in this application even though their absorption efficiency is less than 100%.

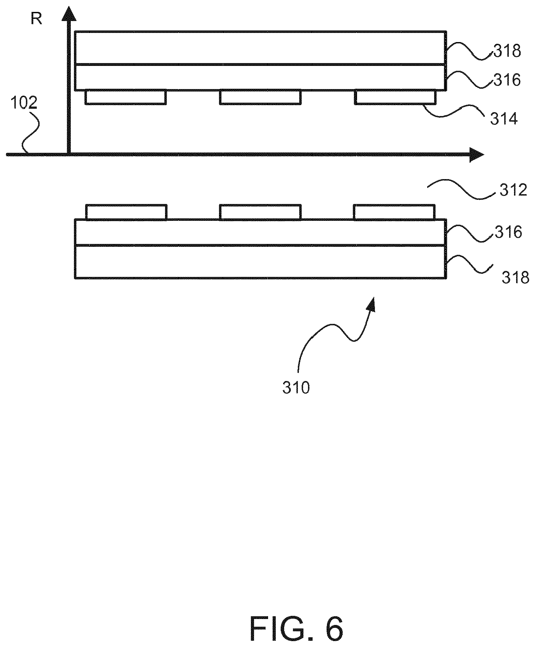

FIG. 6 schematically shows a plane through the passive monochromator 310 which has these absorbing structures 314 embedded in an inner wall. These absorbing structures 314 may take any one of a number of forms such as metallic blocks, graphene flakes or a combination of both, printed atop a transparent electrode layer 316 disposed on a metallic wall 318. Other configurations such as graphene ribbons are also known and within the scope of this disclosure.

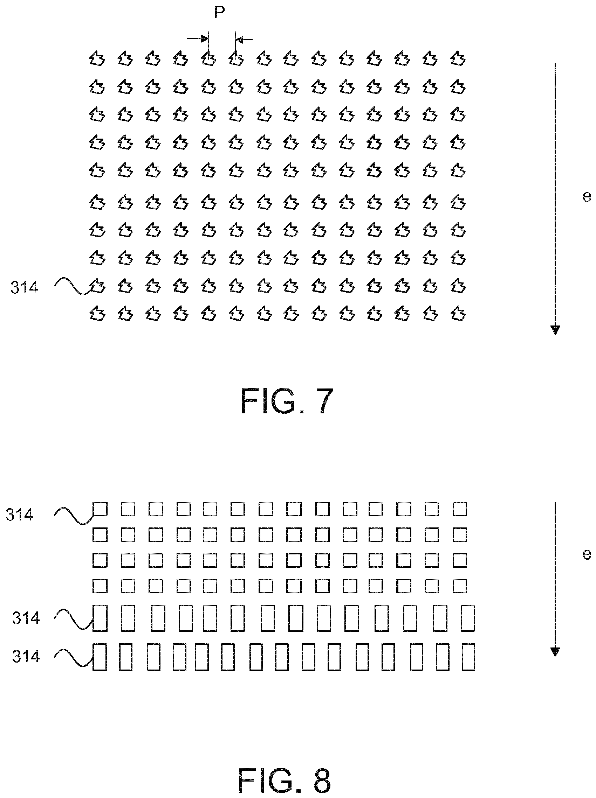

FIG. 7 is a diagrammatic plan view of absorbing structures 314 and embedded in the transparent electrode layer 316. In the particular arrangement shown, the absorbing structures 314 are graphene flakes but, as stated above, other absorbing structures may be used. The absorbing structures 314 together with the transparent electrode layer 316 comprise what is referred to as perfect absorber or as a metamaterial absorber, that is, a material engineered to efficiently absorb electromagnetic radiation. It will be seen that the absorbing structures 314 are embedded in the transparent electrode layer 316 in a periodic array having a pitch P. In addition to tuning of the performance of the metamaterial absorber by choosing the geometry (shape and dimensions) and material for the absorbing structures 314, the performance of the metamaterial absorber can also be tuned by altering the pitch P. For instance, at the beginning of the column, the absorbing structures 314 can be selected to interact efficiently with energetic electrons and later in the column the absorbing structures can be selected and configured to decelerate more efficiently the less energetic electron. FIG. 8 shows a metamaterial absorber implemented as an array of metallic blocks 314. The blocks are varied in terms of shape and pitch in the direction of propagation of the electron beam e.

As discussed above, it is desirable in some applications to use a transparent electrode which acts as a dielectric with respect to electromagnetic radiation but which conducts charges. The transparent conductive electrode may for example be indium-tin-oxide, doped zinc oxide, carbon nanotubes, amorphous material, a doped transparent semiconductor, or a conductive polymer. The transparent conductive electrode may for example be a transparent material and coating of a conductive material with the coating, for example, being gold, aluminum, titanium, or chromium.

The deceleration of electrons is a function of electron velocity or energy. Highly energetic electrons interact strongly with electromagnetic modes at a particular frequency than the less energetic electrons. As a result, energetic electrons will also decelerate more than less energetic ones. Once the electrons have decelerated sufficiently, their interaction with absorbers will become so weak that the electrons will cease to exhibit any noticeable shift in their energy. Hence, the output electron beam will have electrons with substantially identical energies. Additionally, the length of the part of the monochromator traversed by the electron beam may also be chosen such as to cause only a predetermined amount of deceleration of the incident electrons.

While the above arrangement is described in connection with its use as a monochromator, it would be equally useful to passively downconvert the electron beam energy without applying decelerating potentials.

In general, there are many candidates for metamaterial absorbing structures each having its own advantages. In practice, design constraints imposed by a particular application will determine selection of the best candidate. For example, in accordance with one aspect of an embodiment, it may be desirable to decelerate the electrons by absorbing in the optical band or the THz band. Metamaterial absorber structures may take the form of a graphene micro-ribbon or potentially even a flat film.

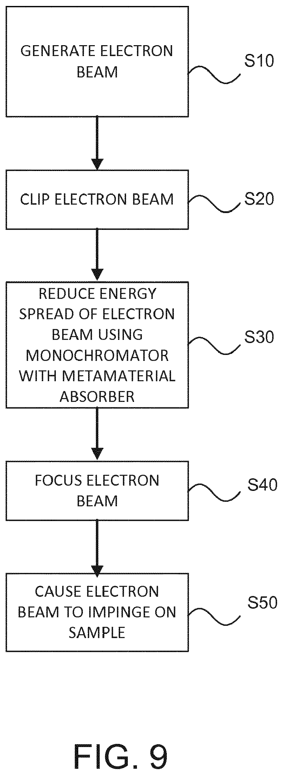

According to another aspect of an embodiment, there is disclosed a method of using a metamaterial absorber to reduce the energy spread of an electron beam. With reference to FIG. 9 in a first step S10 the electron beam is generated. Then, in a step S20, the electron beam is "clipped", that is, passed through an aperture. In a step S30 the energy spread of electron beam is reduced using a monochromator with a metamaterial absorber. In a step S40 the electron beam which is at this point substantially monochromatic is focused, generally using a condenser lens. In a step S50 the focused electron beam is caused to impinge on a sample to illuminate the sample with the electron beam.

The embodiments may further be described using the following clauses:
1. An apparatus for narrowing an energy spread of an electron beam, the apparatus comprising:
   structure defining a cavity extending along a part of a path of the electron beam, the cavity having an interior surface; and
   a metamaterial absorber provided on the interior surface.
2. An apparatus as recited in clause 1 wherein the metamaterial absorber comprises a layer of a dielectric material on at least part of the interior surface wherein the layer of a transparent conductive material is provided with a plurality of absorbing structures.
3. An apparatus as recited in clause 1 wherein the metamaterial absorber comprises a layer of a transparent conductive material on at least part of the interior surface wherein the layer of a transparent conductive material is provided with a plurality of absorbing structures.
4. An apparatus as recited in clause 3 wherein the absorbing structures are metamaterial perfect absorbers.
5. An apparatus as recited in clause 3 wherein the absorbing structures are plasmonic structures.
6. An apparatus as recited in clause 3 wherein the absorbing structures resonantly absorb electromagnetic energy.
7. An apparatus as recited in clause 3 wherein the absorbing structures are at least partially embedded in the layer of transparent conductive material.
8. An apparatus as recited in clause 3 wherein the absorbing structures are fabricated on top of the layer of transparent conductive material.
9. An apparatus as recited in clause 3 wherein the absorbing structures are printed on the layer of transparent conductive material.
10. An apparatus as recited in clause 3 wherein the absorbing structures comprise a plurality of block-shaped elements comprising a metallic material.
11. An apparatus as recited in clause 3 wherein the absorbing structures comprise graphene.
12. An apparatus as recited in clause 3 wherein the absorbing structures comprise a plurality of graphene flakes.
13. An apparatus as recited in clause 3 wherein the absorbing structures comprise a combination of a plurality of block-shaped metallic elements and a plurality of graphene flakes.
14. An apparatus as recited in clause 3 wherein the absorbing structures are arranged in a periodic array.
15. An apparatus as recited in clause 14 wherein a pitch of the periodic array is selected to achieve maximum absorption of energy from the electron beam.
16. An apparatus as recited in clause 3 wherein the transparent conductive material comprises indium-tin-oxide.
17. An apparatus as recited in clause 3 wherein the transparent conductive material comprises doped zinc oxide.
18. An apparatus as recited in clause 3 wherein the transparent conductive material comprises carbon nanotubes.
19. An apparatus for as recited in clause 3 wherein the transparent conductive material an amorphous material.
20. An apparatus as recited in clause 3 wherein the transparent conductive material comprises a doped transparent semiconductor.
21. An apparatus as recited in clause 3 wherein the transparent conductive material comprises a conductive polymer.
22. An apparatus as recited in clause 3 wherein the transparent conductive material comprises a body comprising a transparent material and coating of a conductive material.
23. An apparatus as recited in clause 22 wherein the coating of a conductive material comprises gold.
24. An apparatus as recited in clause 22 wherein the coating of a conductive material comprises aluminum.
25. An apparatus as recited in clause 22 wherein the coating of a conductive material comprises titanium.
26. An apparatus as recited in clause 22 wherein the coating of a conductive material comprises chromium.
27. An apparatus as recited in clause 1 wherein the structure comprises a substantially cylindrical column.
28. An apparatus as recited in clause 27 wherein a length of a part of the column traversed by the electron beam is chosen to cause a predetermined amount of deceleration of electrons in the electron beam.
29. An apparatus as recited in clause 27 wherein the substantially cylindrical column comprises an electrically conductive material.
30. An apparatus as recited in clause 29 wherein the electrically conductive material comprises gold.
31. An apparatus as recited in clause 29 wherein the electrically conductive material comprises silver.
32. An apparatus as recited in clause 28 wherein the electron beam propagates along a central axis of the column.
33. An apparatus as recited in clause 28 wherein the radius of the substantially cylindrical column decreases in a direction the electron beam propagates.
34. An apparatus as recited in clause 3 wherein dimensions of the absorbing structures vary in a direction in which the electron beam propagates.
35. An apparatus for generating a substantially monochromatic electron beam, the apparatus comprising:
   a source of an electron beam;
   a monochromator comprising a metamaterial absorber arranged to interact with the electron beam to produce a substantially monochromatic electron beam; and
   an objective lens arranged to focus the substantially monochromatic electron beam.
36. An apparatus as recited in clause 35 wherein the monochromator comprises a structure defining a cavity having an interior surface and a metamaterial absorber provided on the interior surface.
37. An apparatus as recited in clause 36 wherein the metamaterial absorber comprises a layer of a transparent conductive material on at least part of the interior surface wherein the layer of a transparent conductive material is provided with a plurality of absorbing structures.
38. An apparatus as recited in clause 37 wherein the absorbing structures are metamaterial perfect absorbers.
39. An apparatus as recited in clause 37 wherein the absorbing structures comprise plasmonic absorbers.
40. An apparatus as recited in clause 37 wherein the absorbing structures resonantly absorb electromagnetic energy.
41. An apparatus as recited in clause 37 wherein the absorbing structures are at least partially embedded in the layer of transparent conductive material.
42. An apparatus as recited in clause 37 wherein the absorbing structures are fabricated on top of the layer of transparent conductive material.
43. An apparatus as recited in clause 37 wherein the absorbing structures are printed on the layer of transparent conductive material.
44. An apparatus as recited in clause 37 wherein the absorbing structures comprise a plurality of block-shaped elements comprising a metallic material.
45. An apparatus as recited in clause 37 wherein the absorbing structures comprise graphene.
46. An apparatus as recited in clause 37 wherein the absorbing structures comprise a plurality of graphene flakes.
47. An apparatus as recited in clause 37 wherein the absorbing structures comprise a combination of a plurality of block-shaped metallic elements and a plurality of graphene flakes.
48. An apparatus as recited in clause 37wherein the absorbing structures are arranged in a periodic array.
49. An apparatus as recited in clause 48 wherein a pitch of the periodic array is selected to achieve maximum absorption of energy from the electron beam.
50. An apparatus as recited in clause 37 wherein the transparent conductive material comprises indium-tin-oxide.
51. An apparatus as recited in clause 37 wherein the transparent conductive material comprises doped zinc oxide.
52. An apparatus as recited in clause 37 wherein the transparent conductive material comprises carbon nanotubes.
53. An apparatus as recited in clause 37 wherein the transparent conductive material an amorphous material.
54. An apparatus as recited in clause 37 wherein the transparent conductive material comprises a doped transparent semiconductor.
55. An apparatus as recited in clause 37 wherein the transparent conductive material comprises a conductive polymer.
56. An apparatus as recited in clause 37 wherein the transparent conductive material comprises a body comprising a transparent material and coating of a conductive material.
57. An apparatus as recited in clause 56 wherein the coating of a conductive material comprises gold.
58. An apparatus as recited in clause 56 wherein the coating of a conductive material comprises aluminum.
59. An apparatus as recited in clause 56 wherein the coating of a conductive material comprises titanium.
60. An apparatus as recited in clause 56 wherein the coating of a conductive material comprises chromium.
61. An apparatus as recited in clause 36 wherein the structure comprises a column comprising an electrically conductive material.
62. An apparatus as recited in clause 61 wherein the electrically conductive material comprises gold.
63. An apparatus as recited in clause 61 wherein the electrically conductive material comprises silver.
64. An apparatus as recited in clause 61 wherein the column is substantially cylindrical.
65. An apparatus as recited in clause 61 wherein a length of part of the column traversed by the electron beam is chosen to cause a predetermined amount of deceleration of electrons in the electron beam.
66. An apparatus as recited in clause 64 wherein the electron beam propagates along a central axis of the column.
67. An apparatus as recited in clause 66 wherein the radius of the column decreases in a direction the electron beam propagates.
68. An apparatus as recited in clause 36 wherein geometric properties of the absorbing structures vary in a direction in which the electron beam propagates.
69. An apparatus for generating a substantially monochromatic electron beam, the apparatus comprising:
   a first aperture arranged to obstruct part of the electron beam to produce a modified electron beam;
   at least one electromagnetic condenser lens arranged to collimate the modified electron beam to produce a collimated electron beam;
   a second aperture arranged to obstruct part of the collimated electron beam to produce a modified collimated electron beam;
   a passive monochromator comprising a metamaterial absorber arranged to interact with the modified collimated electron beam to arrow an energy spread of the electron beam; and
   an objective lens arranged to focus the electron beam from the passive monochromator.
70. An apparatus as recited in clause 69 wherein the passive monochromator comprises a structure defining a cavity having an interior surface and a metamaterial absorber provided on the interior surface.
71. An apparatus as recited in clause 70 wherein the metamaterial absorber comprises a layer of a transparent conductive material on at least part of the interior surface wherein the layer of a transparent conductive material is provided with absorbing structures.
72. An apparatus as recited in clause 71 wherein the absorbing structures comprise plasmonic absorbers.
73. An apparatus as recited in clause 71 wherein the absorbing structures resonantly absorb electromagnetic energy.
74. An apparatus as recited in clause 71 wherein the absorbing structures are at least partially embedded in the layer of transparent conductive material.
75. An apparatus as recited in clause 71 wherein the absorbing structures are fabricated on top of the layer of transparent conductive material.
76. An apparatus as recited in clause 71 wherein the absorbing structures are printed on the layer of transparent conductive material.
77. An apparatus as recited in clause 71 wherein the absorbing structures comprise a plurality of block-shaped elements comprising a metallic material.
78. An apparatus as recited in clause 71 wherein the absorbing structures comprise graphene.
79. An apparatus as recited in clause 71 wherein the absorbing structures comprise a plurality of graphene flakes.
80. An apparatus as recited in clause 71 wherein the absorbing structures comprise a combination of a plurality of block-shaped metallic elements and a plurality of graphene flakes.
81. An apparatus as recited in clause 71 wherein the absorbing structures are arranged in a periodic array.
82. An apparatus as recited in clause 81 wherein a pitch of the periodic array is selected to achieve maximum absorption of energy from the electron beam.
83. An apparatus as recited in clause 71 wherein the transparent conductive material comprises indium-tin-oxide.
84. An apparatus as recited in clause 71 wherein the transparent conductive material comprises doped zinc oxide.
85. An apparatus as recited in clause 71 wherein the transparent conductive material comprises carbon nanotubes.
86. An apparatus as recited in clause 71 wherein the transparent conductive material an amorphous material.
87. An apparatus as recited in clause 71 wherein the transparent conductive material comprises a doped transparent semiconductor.
88. An apparatus as recited in clause 71 wherein the transparent conductive material comprises a conductive polymer.
89. An apparatus as recited in clause 71 wherein the transparent conductive material comprises a body comprising a transparent material and coating of a conductive material.
90. An apparatus as recited in clause 89 wherein the coating of a conductive material comprises gold.
91. An apparatus as recited in clause 89 wherein the coating of a conductive material comprises aluminum.
92. An apparatus as recited in clause 89 wherein the coating of a conductive material comprises titanium.
93. An apparatus as recited in clause 89 wherein the coating of a conductive material comprises chromium.
94. An apparatus as recited in clause 70 wherein the structure comprises a column comprising an electrically conductive material.
95. An apparatus as recited in clause 94 wherein the electrically conductive material comprises gold.
96. An apparatus as recited in clause 94 wherein the electrically conductive material comprises silver.
97. An apparatus as recited in clause 94 wherein the column is substantially cylindrical.
98. An apparatus as recited in clause 94 wherein the electron beam propagates along a central axis of the column.
99. An apparatus as recited in clause 94 wherein the radius of the column decreases in a direction the electron beam propagates.
100. An apparatus as recited in clause 94 wherein a length of the part of the column traversed by the electron beam is chosen to cause a predetermined amount of deceleration of electrons in the electron beam.
101. An apparatus as recited in clause 71 wherein geometric properties of the absorbing structures vary in a direction in which the electron beam propagates.
102. An apparatus for narrowing an energy spread of an electron beam, the apparatus comprising:
   structure defining a cavity extending along a part of a path of the electron beam, the cavity having an interior surface, the interior surface being adapted to absorb energy from electrons in the electron beam to narrow an energy spread of the electron beam.
103. An apparatus as recited in clause 102 wherein the interior surface comprises a metamaterial absorber.
104. An apparatus as recited in clause 103 wherein the metamaterial absorber comprises a layer of a transparent conductive material on at least part of the interior surface wherein the layer of a transparent conductive material is provided with absorbing structures.
105. An apparatus as recited in clause 104 wherein the absorbing structures comprise plasmonic absorbers.
106. An apparatus as recited in clause 104 wherein the absorbing structures resonantly absorb electromagnetic energy.
107. An apparatus as recited in clause 104 wherein the absorbing structures are at least partially embedded in the layer of transparent conductive material.
108. An apparatus as recited in clause 104 wherein the absorbing structures are fabricated on top of the layer of transparent conductive material.
109. An apparatus as recited in clause 104 wherein the absorbing structures are printed on the layer of transparent conductive material.
110. An apparatus as recited in clause 104 wherein the absorbing structures comprise a plurality of block-shaped elements comprising a metallic material.
111. An apparatus as recited in clause 104 wherein the absorbing structures comprise graphene.
112. An apparatus as recited in clause 104 wherein the absorbing structures comprise a plurality of graphene flakes.
113. An apparatus as recited in clause 104 wherein the absorbing structures comprise a combination of a plurality of block-shaped metallic elements and a plurality of graphene flakes.
114. An apparatus as recited in clause 104 wherein the absorbing structures are arranged in a periodic array.
115. An apparatus as recited in clause 114 wherein a pitch of the periodic array is selected to achieve maximum absorption of energy from the electron beam.
116. An apparatus as recited in clause 104 wherein the transparent conductive material comprises indium-tin-oxide.
117. An apparatus as recited in clause 104 wherein the transparent conductive material comprises doped zinc oxide.
118. An apparatus as recited in clause 104 wherein the transparent conductive material comprises carbon nanotubes.
119. An apparatus as recited in clause 104 wherein the transparent conductive material an amorphous material.
120. An apparatus as recited in clause 104 wherein the transparent conductive material comprises a doped transparent semiconductor.
121. An apparatus as recited in clause 104 wherein the transparent conductive material comprises a conductive polymer.
122. An apparatus as recited in clause 104 wherein the transparent conductive material comprises a body comprising a transparent material and coating of a conductive material.
123. An apparatus as recited in clause 122 wherein the coating of a conductive material comprises gold.
124. An apparatus as recited in clause 122 wherein the coating of a conductive material comprises aluminum.
125. An apparatus as recited in clause 122 wherein the coating of a conductive material comprises titanium.
126. An apparatus as recited in clause 122 wherein the coating of a conductive material comprises chromium.
127. An apparatus as recited in clause 102 wherein the structure comprises a column comprising an electrically conductive material.
128. An apparatus as recited in clause 127 wherein the electrically conductive material comprises gold.
129. An apparatus as recited in clause 127 wherein the electrically conductive material comprises silver.
130. An apparatus as recited in clause 127 wherein the column is substantially cylindrical.
131. An apparatus as recited in clause 130 wherein the electron beam propagates along a central axis of the column.
132. An apparatus as recited in clause 130 wherein the radius of the column decreases in a direction the electron beam propagates.
133. An apparatus as recited in clause 130 wherein a length of the part of the column traversed by the electron beam is chosen to cause a predetermined amount of deceleration of electrons in the electron beam.
134. An apparatus as recited in clause 104 wherein geometric properties of the absorbing structures vary in a direction in which the electron beam propagates.
135. A method of reducing a width of an energy distribution in a beam of electrons, the method comprising the step of passing the beam through a volume of space defined by a structure extending along a path of the beam, the structure having a surface provided with a metamaterial absorber arranged to absorb energy from the electrons.
136. A method as recited in clause 135 wherein the metamaterial absorber comprises a layer of a transparent conductive material on at least part of the surface wherein the layer of a transparent conductive material is provided with a plurality of absorbing structures.
137. A method as recited in clause 136 wherein the absorbing structures are metamaterial perfect absorbers.
138. A method as recited in clause 136 wherein the absorbing structures are plasmonic structures.
139. A method as recited in clause 136 wherein the absorbing structures resonantly absorb electromagnetic energy.
140. A method as recited in clause 136 wherein the absorbing structures are at least partially embedded in the layer of transparent conductive material.
141. A method as recited in clause 136 wherein the absorbing structures are fabricated on top of the layer of transparent conductive material.
142. A method as recited in clause 136 wherein the absorbing structures are printed on the layer of transparent conductive material.
143. A method as recited in clause 136 wherein the absorbing structures comprise a plurality of block-shaped elements comprising a metallic material.
144. A method as recited in clause 136 wherein the absorbing structures comprise graphene.
145. A method as recited in clause 136 wherein the absorbing structures comprise a plurality of graphene flakes.
146. A method as recited in clause 136 wherein the absorbing structures comprise a combination of a plurality of block-shaped metallic elements and a plurality of graphene flakes.
147. A method as recited in clause 136 wherein the absorbing structures are arranged in a periodic array.
148. A method as recited in clause 147 wherein a pitch of the periodic array is selected to achieve maximum absorption of energy from the electron beam.
149. A method as recited in clause 136 wherein the transparent conductive material comprises indium-tin-oxide.
150. A method as recited in clause 136 wherein the transparent conductive material comprises doped zinc oxide.
151. A method as recited in clause 136 wherein the transparent conductive material comprises carbon nanotubes.
152. A method as recited in clause 136 wherein the transparent conductive material an amorphous material.
153. A method as recited in clause 136 wherein the transparent conductive material comprises a doped transparent semiconductor.
154. A method as recited in clause 136 wherein the transparent conductive material comprises a conductive polymer.
155. A method as recited in clause 136 wherein the transparent conductive material comprises a body comprising a transparent material and coating of a conductive material.
156. A method as recited in clause 155 wherein the coating of a conductive material comprises gold.
157. A method as recited in clause 155 wherein the coating of a conductive material comprises aluminum.
158. A method as recited in clause 155 wherein the coating of a conductive material comprises titanium.
159. A method as recited in clause 155 wherein the coating of a conductive material comprises chromium.
160. A method as recited in clause 135 wherein the structure comprises a substantially cylindrical column.
161. A method as recited in clause 160 wherein the substantially cylindrical column comprises an electrically conductive material.
162. A method as recited in clause 160 wherein the electron beam propagates along a central axis of the column.
163. A method as recited in clause 160 wherein the radius of the substantially cylindrical column decreases in a direction the electron beam propagates.
164. A method as recited in clause 160 wherein a length of the part of the column traversed by the electron beam is chosen to cause a predetermined amount of deceleration of electrons in the electron beam.
165. A method as recited in clause 136 wherein dimensions of the absorbing structures vary in a direction in which the electron beam propagates.

The foregoing description of the specific embodiments will so fully reveal the general nature of the present invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

## Claims

1. An apparatus for narrowing an energy spread of an electron beam, the apparatus comprising:
structure defining a cavity extending along a part of a path of the electron beam, the cavity having an interior surface; and
a metamaterial absorber provided on the interior surface.

2. An apparatus as claimed in claim 1 wherein the metamaterial absorber comprises a layer of a dielectric material on at least part of the interior surface wherein the layer of a transparent conductive material is provided with a plurality of absorbing structures.

3. An apparatus as claimed in claim 1 wherein the metamaterial absorber comprises a layer of a transparent conductive material on at least part of the interior surface wherein the layer of a transparent conductive material is provided with a plurality of absorbing structures.

4. An apparatus as claimed in claim 3 wherein the absorbing structures are metamaterial perfect absorbers.

5. An apparatus as claimed in claim 3 wherein the absorbing structures are plasmonic structures.

6. An apparatus as claimed in claim 3 wherein the absorbing structures resonantly absorb electromagnetic energy.

7. An apparatus as claimed in claim 3 wherein the absorbing structures are at least partially embedded in the layer of transparent conductive material.

8. An apparatus as claimed in claim 3 wherein the absorbing structures are fabricated on top of the layer of transparent conductive material.

9. An apparatus as claimed in claim 3 wherein the absorbing structures are printed on the layer of transparent conductive material.

10. An apparatus as claimed in claim 3 wherein the absorbing structures comprise a plurality of block-shaped elements comprising a metallic material.

11. An apparatus as claimed in claim 3 wherein the absorbing structures comprise graphene.

12. An apparatus as claimed in claim 3 wherein the absorbing structures comprise a plurality of graphene flakes.

13. An apparatus as claimed in claim 3 wherein the absorbing structures comprise a combination of a plurality of block-shaped metallic elements and a plurality of graphene flakes.

14. An apparatus as claimed in claim 3 wherein the absorbing structures are arranged in a periodic array.

15. A method of reducing a width of an energy distribution in a beam of electrons, the method comprising the step of passing the beam through a volume of space defined by a structure extending along a path of the beam, the structure having a surface provided with a metamaterial absorber arranged to absorb energy from the electrons.
